# Europäisches Patentamt
# European Patent Office
# Office européen des brevets

(19)

(11) Numéro de publication: **0 152 126**
**B1**

(12)

# FASCICULE DE BREVET EUROPÉEN

(45) Date de publication du fascicule du brevet:
**20.07.88**

(51) Int. Cl.⁴: **H 01 L 29/80,** H 01 L 29/52,
H 01 L 21/28

(21) Numéro de dépôt: **85200045.4**

(22) Date de dépôt: **18.01.85**

(54) Transistor à effet de champ de type MESTEC pour applications hyperfréquences et procédé de réalisation permettant d'obtenir un tel transistor.

(30) Priorité: **23.01.84 FR 8400981**

(43) Date de publication de la demande:
**21.06.85 Bulletin 85/34**

(45) Mention de la délivrance du brevet:
**20.07.88 Bulletin 88/29**

(84) Etats contractants désignés:
**DE FR GB NL**

(56) Documents cité:
EP-A-0 022 383
FR-A-2 335 041
FR-A-2 369 689
US-A-4 156 879
US-A-4 375 643

(73) Titulaire: **Laboratoires d'Electronique et de Physique Appliquée L.E.P., 3, Avenue Descartes, F-94450 Limeil- Brévannes (FR)**
(84) Etats contractants désignés: **FR**

(73) Titulaire: **N.V. Philips' Gloeilampenfabrieken, Groenewoudseweg 1, NL- 5621 BA Eindhoven (NL)**
(84) Etats contractants désignés: **DE GB NL**

(72) Inventeur: **Boccon- Gibod, Dominique, Société Civile S.P.I.D. 209 rue de l'Université, F-75007 Paris (FR)**

(74) Mandataire: **Landousy, Christian, Société Civile S.P.I.D. 209, Rue de l'Université, F-75007 Paris (FR)**

## Description

L'invention concerne un transistor à effet de champ, pour applications hyperfréquences, comportant, sur un substrat semi-isolant monocristallin, une couche mince active dopée N d'un matériau présentant une mobilité électronique élevée, à la surface de laquelle est déposée une couche métallique constituant deux contacts ohmiques qui forment les régions d'accès source et drain du transistor, entre lesquels un contact métallique constitue l'électrode de grille de type Schottky, et comportant une couche diélectrique disposée sur la couche active, entre les électrodes de source et de grille d'une part et entre les électrodes de grille et de drain d'autre part.

Ce transistor peut être utilisé soit comme élément discret, soit comme élément d'un cicuit intégré et trouve son application dans le domaine des hyperfréquences.

L'invention concerne également un procédé de réalisation de ce transistor.

Un tel transistor et un procédé de réalisation correspondant sont par exemple décrits dans la demande de brevet EP-A-0 022 383. Un procédé de réalisation d'un transistor à effet de champ à l'arséniure de gallium ayant une grille à barrière de Schottky formée à l'intérieur d'une région rétrécie du canal est divulgué dans la demande de brevet FR-A-2 335 041.

Un transistor similaire est connu de l'art antérieur par la publication de D. Boccon-Gibod dans ACTA ELECTRONICA 23, 2, 1980, p. 99-109 intitulée "Modèle analytique et schéma équivalent du transistor à effet de champ en arséniure de gallium.

Le transistor décrit dans la publicaton précitée est un MESTEC (MEtal-Semiconducteur-Transistor à effet de Champ) en arséniure de gallium (GaAs). Un substrat monocristallin en arséniure de gallium semi-isolant sert de support à une couche mince d'arséniure de gallium dopé N. A la surface de la couche N, se trouvent deux contacts ohmiques formant la source et le drain, entre lesquels une diode Schottky réalise le contact de grille et a pour effet de créer une zone désertée dont l'épaisseur dépend essentiellement du dopage de la couche N, et peu du métal constituant la grille.

Sous la grille, dans la direction drain-source, circule un courant dont la valeur dépend des propriétés physiques de la couche N et de la forme géométrique du canal conducteur. L'application d'une tension $V_{GS}$ entre la grille et la source modifie la géométrie du canal, en particulier son épaisseur et donc la valeur du courant $I_D$ traversant le transistor, pour une tension $V_{DS}$ entre le drain et la source.

La publication de C. Azizi et P. Rossel dans ACTA ELECTRONICA 23,3,1980 p.205-221, intitulée "Modèles mathématiques du transistor à effet de champ en GaAs, pour la conception assistée par ordinateur des circuits" décrit le fonctionnement de ce transistor et en fournit un schéma équivalent. Les contacts de drain et source forment avec l'arséniure de gallium des zones d'accès qui constituent des résistances en série avec la partie active du transistor.

Ce schéma équivalent montre qu'il y tout intérêt, pour améliorer les performances du transistor, à diminuer ces résistances d'accès. Or les travaux menés ces dernières années ont prouvé qu'un tel transistor à effet de champ, réalisé en un matériau présentant une mobilité électronique élevée, est particulièrement bien adapté à la conception de circuits hyperfréquences.

C'est pourquoi l'objet de la présente invention est de présenter un nouveau transistor à effet de champ dont les résistances d'accès sont diminuées en hyperfréquences.

A cet effet, ce transistor à effet de champ, tel que décrit dans le préambule, est remarquable en ce que la couche métallique constituant les contacts ohmiques se prolonge continûment sur cette couche diélectrique, sans cependant faire court-circuit avec la grille, formant ainsi des capacités dans la couche diélectrique entre la couche métallique et la couche active sousjacente pour diminuer les résistances d'accès.

Dans ces conditions les résistances d'accès source-grille et grille-drain sont diminuées, du fait qu'il s'établit, en hyperfréquences, une capacité dans chacune de ces couches diélectriques, entre la couche métallique du contact ohmique qui les recouvre et la couche active de type N sousjacente.

La présente invention vise à fournir en outre un procédé de réalisation d'un tel transistor, ce procédé comprenant les étapes suivantes:

a) formation d'un substrat monocristallin semi-isolant pourvu d'une couche monocristalline de type N,

b) dépôt d'une couche diélectrique présentant des ouvertures délimitant les contacts de source et drain,

c) dépôt d'une couche métallique continue d'un composé métallique propre à former les contacts ohmiques de source et drain,

d) dépôt d'une couche diélectrique épaisse,

e) dépôt d'une couche de laque photosensible qui après traitement délimite l'ouverture correspondant au contact de grille,

f) gravure, par cette ouverture, au moyen d'une série d'attaques chimiques sélectives de la couche diélectrique épaisse, de la couche métallique continue, de la couche diélectrique et d'une partie de l'épaisseur de la couche active N, de manière à y pratiquer une cavité,

g) dépôt d'une couche métallique propre à constituer le contact de grille, couvrant l'ensemble du transistor et en particulier le fond de cette cavité,

h) dissolution de la couche de laque photosensible, entraînant la couche métallique supérieure, tout en conservant la partie de cette couche qui s'est déposée dans la cavité et qui constitue la grille, et

i) dissolution totale ou partielle de la couche diélectrique épaisse.

Selon une variante de ce procédé de réalisation, il peut être fait, dans les ouvertures délimitant les contacts ohmiques de source et drain, avant le dépôt de la couche métallique qui constitue ces contacts, des caissons de type N+ dans la couche active N.

Selon une réalisation particulière, où le transistor est en arséniure de gallium, la couche active peut être réalisée par implantation localisée d'ions sélénium (Se+) et les caissons par implantation localisée d'ions soufre (S+).

Selon une mise en oeuvre de l'un de ces procédés de réalisation, la couche diélectrique, dans laquelle sont réalisées les ouvertures de source et drain, peut être une laque photosensible.

Selon une mise en oeuvre de l'un de ces procédés de réalisation, la couche métallique constituant les contacts ohmiques et couvrant la couche diélectrique peut être un alliage or-germanium.

Enfin selon une mise en oeuvre de l'un de ces procédés de réalisation, le contact de grille peut être constitué d'une multicouche Ti-Pt-Au ou Cr-Pt-Au.

La description suivante en se référant aux figures annexées fera mieux comprendre les particularités du transistor selon la présente invention ainsi que son procédé de réalisation.

La figure 1a représente, en coupe transversale, un transistor selon la présente invention et la figure 1b, ce même transistor vu du dessus.

La figure 2 représente les différentes étapes du procédé de réalisation d'un transistor selon la présente invention.

La figure 3 représente le schéma équivalent au transistor en fonctionnement en hyperfréquences.

Les figures sont représentées schématiquement. Pour la clarté du dessin, les dimensions dans le sens de l'épaisseur de la coupe transversale, sont fortement exagérées.

D'une façon générale, les zones de même type sont hachurées de la même façon. Dans les différentes figures les parties correspondantes sont désignées par les mêmes chiffres de référence.

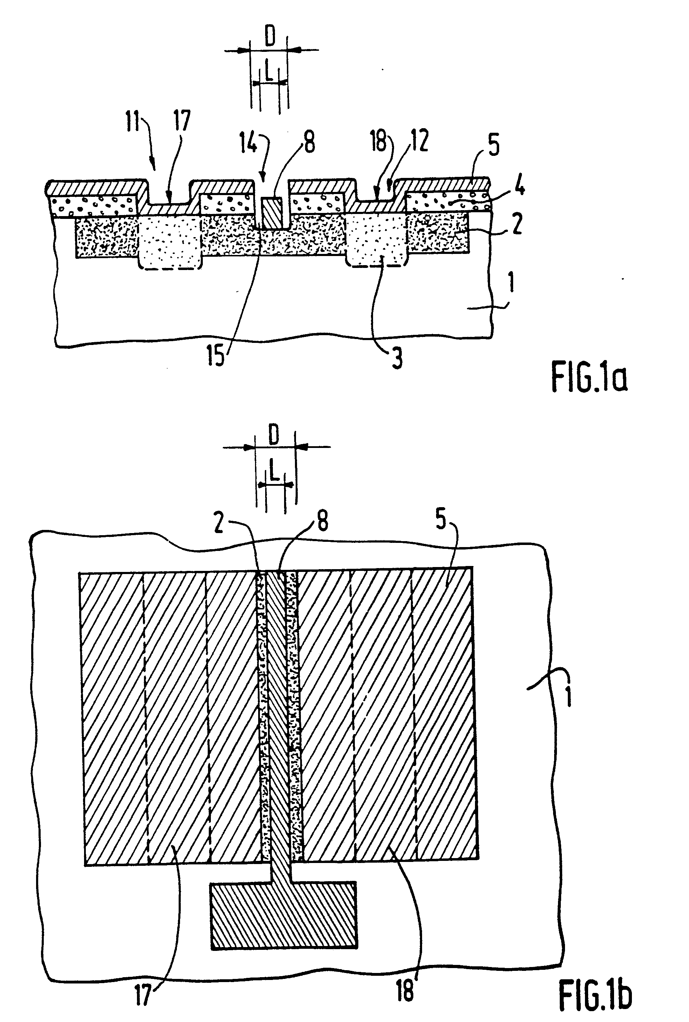

Tel que représenté sur la figure 1a, le transistor à effet de champ selon l'invention comprend, sur un substrat semi-isolant 1, de forte résistivité, une couche active 2, de type N, recouverte d'une couche diélectrique 4. Cette dernière présente, d'une part, deux ouvertures 11 et 12 délimitant l'emplacement des contacts de source et drain 17 et 18 respectivement, et d'autre part, entre ces ouvertures, une troisième ouverture 14 délimitant l'emplacement du contact de grille 8. L'ouverture 14 est prolongée jusque dans la couche active 2, de manière à y former une cavité 15, alors que les ouvertures 11 et 12 en dégagent seulement la surface. Une couche métallique 5, de composition appropriée à former les contacts ohmiques avec la couche active, est déposée dans les ouvertures 11 et 12 prévues à cet effet, ainsi que sur la couche diélectrique 4, de manière à couvrir continûment la totalité du transistor, excepté les parois de l'ouverture 14 et les parois et le fond de la cavité 15. Le contact de grille 8 est constitué par le dépôt sur le fond de la cavité 15, creusée dans la couche active, d'un métal approprié à former un contact de type Schottky. La longueur L de la grille 8 est légèrement inférieure à la dimension transversale D de l'ouverture 14 et de la cavité 15, en sorte qu'il ne peut y avoir court-circuit entre la couche métallique 5 et le contact de grille 8.

La figure 1b montre en vue du dessus ce même transistor.

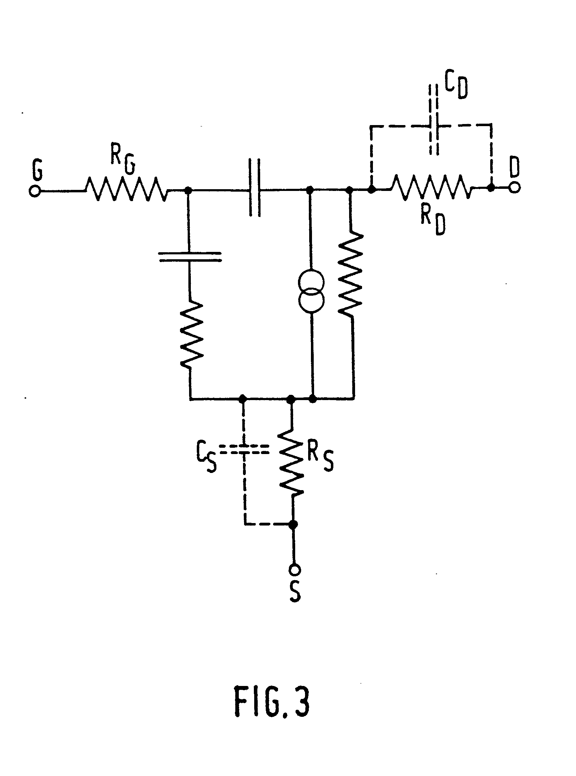

Des capacités existent dans la couche diélectrique 4, entre la couche métallique 5 et la couche active 2. Ces capacités, notées $C_D$ et $C_S$, se placent en parallèle avec les résistances d'accès $R_D$ et $R_S$ respectivement, comme il est montré sur le schéma équivalent du transistor en fonctionnement de la figure 3. En hyperfréquences, elles court-circuitent les résistances $R_D$ et $R_S$, permettant d'améliorer les performances du transistor en fonctionnement et notamment d'augmenter la valeur de la fréquence de coupure.

Dans une réalisation préférentielle d'un tel transistor, des caissons 3 dopés n+ sont formés sous la source et sous le drain. Ces caissons sont connus pour diminuer les résistances dues aux contacts ohmiques.

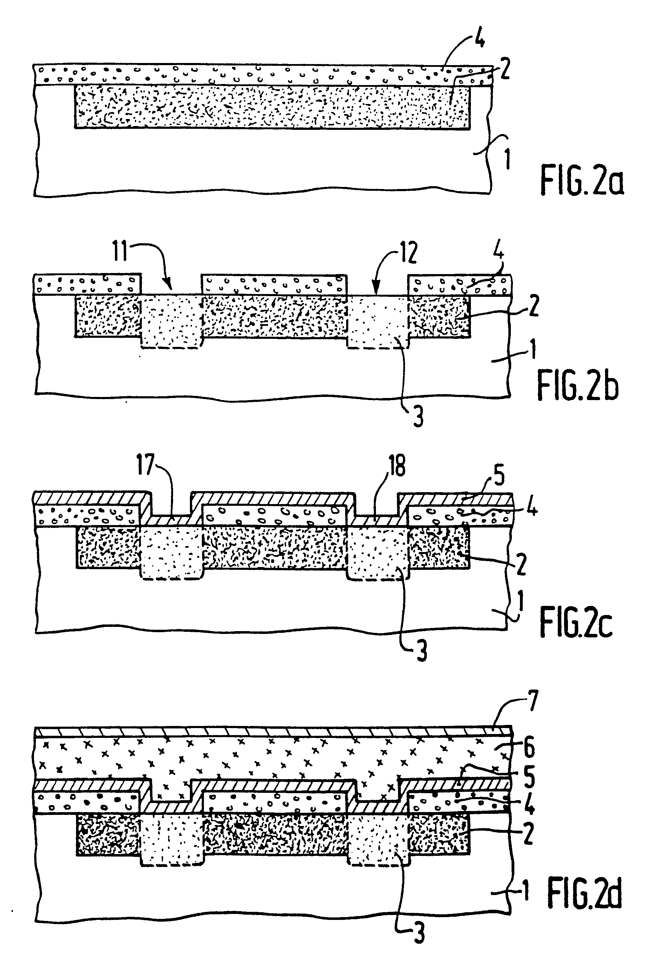

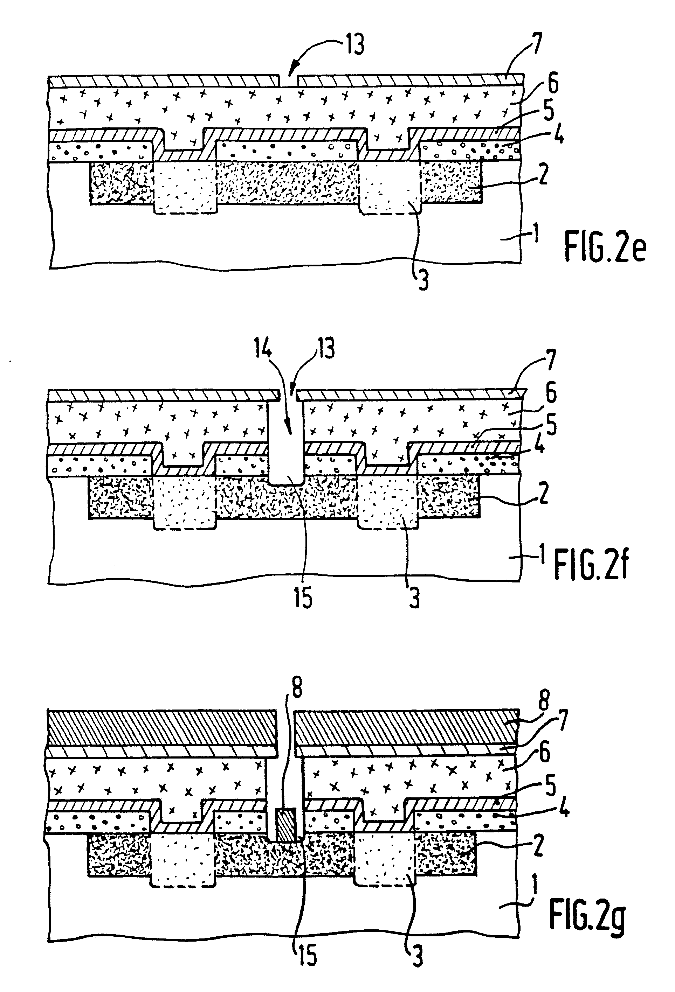

La figure 2 représente les différentes étapes du procédé de réalisation du transistor selon l'invention.

Tel que le montre la figure 2a, ce procédé consiste à partir d'un substrat 1 monocristallin semi-isolant de résistivité élevée, dans lequel est réalisée par implantation ionique par exemple une couche 2, dite active, de type n.

Une couche diélectrique 4 est déposée à la surface de la couche 2, les zones correspondant aux contacts de source et drain sont délimitées par un masque et des ouvertures 11 et 12 sont pratiquées dans ces zones, par un traitement chimique approprié, jusqu'à découvrir la surface de la couche active 2, ce qui est illustré par la figure 2b. La couche diélectrique 4 peut être en laque photosensible, ce qui du point de vue technologique est le plus simple. Cependant, elle peut être en un autre matériau diélectrique, par exemple en silice ($SiO_2$), en nitrure de silicium ($Si_3N_4$) ou en polyimide.

Facultativement, il peut alors être réalisé, par les ouvertures 11 et 12, des caissons 3 de type n+, par exemple par implantation ionique localisée.

La figure 2c montre qu'il est ensuite déposé continûment sur la totalité du transistor une couche métallique 5 d'une composition appropriée à constituer les contacts ohmiques 17 et 18 avec la couche 2 dans les ouvertures 11 et 12 respectivement.

Puis une couche diélectrique 6 épaisse devant les différences de niveau de la couche 5 réalisée par exemple en polyimide ou en silice (SiO$_2$), est déposée sur l'ensemble ainsi constitué. Une couche de photorésist 7 vient couvrir la couche 6. Cette étape du procédé de réalisation est illustrée par la figure 2d.

Sur la couche de photorésist 7, un masque délimite ensuite la position de la grille et un traitement chimique approprié fournit une ouverture 13 dans la couche 7 à cet emplacement, ce qui est montré sur la figure 2e.

Une attaque chimique sélective permet alors de pratiquer par cette ouverture une cavité 14 dans la couche diélectrique épaisse 6, la couche métallique 5 et la couche diélectrique 4, ainsi qu'une cavité 15 de faible profondeur dans la couche active 2. Une légère sous-gravure de la couche de photorésist est en outre pratiquée de manière à ce que la longueur transversale D des cavités 14 et 15 soit légèrement supérieure à celle de l'ouverture 13 de la couche de photorésist qui est choisie égale à la longueur L de grille 8 prévue. Cette étape du procédé est illustrée par la figure 2f.

Sur l'ensemble ainsi constitué est alors déposée une couche métallique 8 d'un métal propre à réaliser un contact de type Schottky sur la couche 2. Cette couche 8 vient couvrir l'ensemble de la couche de photorésist 7, ainsi que partiellement le fond de la cavité 15, sur la longueur délimité par l'ouverture 13 de la couche de photorésist 7, ce qui est montré sur la figure 2g.

Un traitement chimique permet d'éliminer la couche 7 entraînant en même temps la partie de la couche 8 qui la recouvre (procédé dit de LIFT-OFF) sans toutefois détériorer la partie de la couche 8 déposée au fond de la cavité 15 et qui constitue le contact de grille. Un traitement chimique supplémentaire permet d'enlever la seconde couche diélectrique épaisse 6 partiellement ou totalement en fonction des ouvertures qu'il est nécessaire d'ouvrir pour réaliser les connexions électriques du transistor.

Dans une mise en oeuvre particulière de ce procédé de réalisation, le substrat 1 peut être de l'arséniure de gallium monocristallin semi-isolant de résistivité 10$^8$ Ω.cm. La couche active 2 de type n peut alors être réalisée par une implantation ionique localisée d'ions sélénium (Se$^+$). La couche diélectrique 4 peut être constituée de photorésist sur laquelle un alliage Or-Germanium constitue la couche 5 de contact ohmique, après réalisation de caissons 3 de type n$^+$ par implantation ionique localisée d'ions soufre (S$^+$) dans les ouvertures 11 et 12 de la couche 4.

Enfin, après dépôt d'une couche épaisse de diélectrique et d'une couche de photorésist, une multicouche métallique telle que Or-Cuivre-Nickel ou Titane-Platine-Or ou Chrome-Platine-Or peut constituer la couche 8.

Un transistor à effet de champ ainsi réalisé peut être utilisé soit comme élément discret, soit comme élément d'un circuit intégré.

Il est évident que de nombreuses variantes, tant dans la forme et les dimensions de ce transistor que dans les matériaux mis en oeuvre par le procédé de réalisation, peuvent être imaginées, sans sortir du cadre de la présente invention, tel que défini par les revendications ci-après annexées.

**Revendications**

1. Transistor à effet de champ pour applications hyperfréquences, comportant sur un substrat monocristallin semi-isolant, une couche mince active dopée N, d'un matériau présentant une mobilité électronique élevée, à la surface de laquelle est déposée une couche métallique constituant deux contacts ohmiques qui forment les régions d'accès source et drain du transistor entre lesquels un contact métallique constitue l'électrode de grille de type Schottky, et comportant une couche diélectrique disposée sur la couche active, entre les électrodes de source et de grille d'une part et entre les électrodes de grille et de drain d'autre part, caractérisé en ce que la couche métallique constituant les contacts ohmiques se prolonge continûment sur cette couche diélectrique, sans cependant faire court-circuit avec la grille, formant ainsi des capacités dans la couche diélectrique entre la couche métallique et la couche active sousjacente pour diminuer les résistances d'accès.

2. Transistor selon la revendication 1, caractérisé en ce que, dans les régions situées sous la couche métallique qui constitue les contacts ohmiques, des caissons de type N$^+$ sont disposés dans la couche N.

3. Transistor selon la revendication 1 ou 2, caractérisé en ce que le substrat est en arséniure de gallium semi-isolant.

4. Transistor selon l'une des revendications 1 à 3, caractérisé en ce que la couche diélectrique est une couche de laque photosensible.

5. Transistor selon l'une des revendications 1 à 4, caractérisé en ce que la couche métallique constituant les contacts ohmiques et couvrant la couche diélectrique est un alliage or-germanium.

6. Transistor selon l'une des revendications 1 à 5 caractérisé en ce que la couche métallique de contact de grille est constituée de la superposition des métaux Titane, Platine, Or, ou bien Chrome, Platine, Or, formant une multicouche.

7. Procédé de réalisation d'un transistor à effet de champ selon la revendication 1 comprenant les étapes suivantes:

a) formation d'un substrat monocristallin semiisolant pourvu d'une couche monocristalline de type N,

b) dépôt d'une couche diélectrique présentant des ouvertures délimitant les contacts de source et drain,

c) dépôt d'une couche métallique continue d'un composé métallique propre à former les contacts ohmiques de source et drain,

d) dépôt d'une couche diélectrique épaisse,

e) dépôt d'une couche de laque photosensible, qui après traitement délimite l'ouverture correspondant au contact de grille,

f) gravure, par cette ouverture, au moyen d'une série d'attaques chimiques sélectives, de la couche diélectrique épaisse, de la couche métallique continue, de la couche diélectrique et d'une partie de l'épaisseur de la couche active N, de manière à y pratiquer une cavité,

g) dépôt d'une couche métallique propre à constituer le contact de grille, couvrant l'ensemble du transistor et en particulier le fond de cette cavité,

h) dissolution de la couche de laque photosensible entraînant la couche métallique supérieure, tout en conservant la partie de cette couche qui s'est déposée dans la cavité et qui constitue la grille, et

i) dissolution totale ou partielle de la couche diélectrique épaisse.

8. Procédé de réalisation selon la revendication 7, caractérisé en ce que dans les ouvertures délimitant les contacts ohmiques de source et drain, avant le dépôt de la couche métallique qui constitue ces contacts, des caissons de type N+ sont réalisés dans la couche N.

9. Procédé de réalisation selon l'une des revendications 7 ou 8, caractérisé en ce que le substrat est en arséniure de gallium semi-isolant.

10. Procédé de réalisation selon la revendication 9, caractérisé en ce que la couche active de type N est réalisée par implantation localisée d'ions sélénium (Se+) dans le substrat.

11. Procédé de réalisation selon la revendication 8 et l'une des revendications 9 ou 10, caractérisé en ce que les caissons de type N+ sont réalisés par implantation localisée d'ions soufre (S+) dans le substrat.

12. Procédé de réalisation selon l'une des revendications 7 à 11, caractérisé en ce que la couche diélectrique est une couche de laque photosensible.

13. Procédé de réalisation selon l'une des revendications 7 à 12, caractérisé en ce que la couche métallique constituant les contacts ohmiques et couvrant la couche diélectrique est un alliage Or-Germanium.

14. Procédé de réalisation selon l'une des revendications 7 à 13, caractérisé en ce que la couche métallique de contact de grille est constituée de la superposition des matériaux Titane, Platine, Or ou Chrome, Platine, Or formant une multicouche.

**Patentansprüche**

1. Feldeffekttransistor zum Gebrauch im Höchstfrequenzbereich, bei dem sich auf einem monokristallinen halbisolierenden Substrat eine dünne aktive N-dotierte Schicht aus einem Material mit höher elektronischer Beweglichkeit befindet, wobei auf der Oberfläche dieser Schicht eine metallische Schicht niedergeschlagen ist, die zwei ohmsche Kontakte bildet, welche die Source- und Drain-Gebiete des Transistors bilden, zwischen denen ein metallischer Kontakt die Gate-Elektrode vom Schottky-Typ bildet und bei dem auf der aktiven Schicht zwischen der Source- und Gate-Elektrode einerseits und der Gate- und Drain-Elektrode andererseits eine dielektrische Schicht vorgesehen ist, dadurch gekennzeichnet, dass die die ohmschen Kontakte bildende metallische Schicht sich kontinuierlich über diese dielektrische Schicht fortsetzt, ohne dass dabei mit dem Gate ein Kurzschluss gebildet wird, wobei in der dielektrischen Schicht zwischen der metallischen Schicht und der darunter liegenden aktiven Schicht Kapazitäten gebildet werden zum Verringern der Eingangswiderstände.

2. Transistor nach Anspruch 1, dadurch gekennzeichnet, dass in den Gebieten unter der die ohmschen Kontakte bildenden metallischen Schicht in der N-leitenden Schicht N+-leitende Inseln vorgesehen werden.

3. Transistor nach Anspruch 1 oder 2, dadurch gekennzeichnet, dass das Substrat aus halbisolierendem Galliumarsenid besteht.

4. Transistor nach einem der Ansprüche 1 bis 3, dadurch gekennzeichnet, dass die dielektrische Schicht eine photoempfindliche Lackschicht ist.

5. Transistor nach einem der Ansprüche 1 bis 4, dadurch gekennzeichnet, dass die die ohmschen Kontakte bildende und die dielektrische Schicht bedeckende Schicht eine Goldgermaniumlegierung ist.

6. Transistor nach einem der Ansprüche 1 bis 5, dadurch gekennzeichnet, dass die metallische Gate-Kontaktschicht aus der Überlagerung der Metalle Titan, Platin, Gold oder Chrom, Platin, Gold besteht, die eine Mehrfachschicht bilden.

7. Verfahren zum Herstellen eines Feldeffekttransistors nach Anspruch 1, das die folgenden Verfahrensschritte aufweist:

a) das Bilden eines monokristallinen halbisolierenden Substrats mit einer monokristallinen N-leitenden Schicht,

b) das Niederschlagen einer dielektrischen Schicht mit Öffnungen, welche die Source- und Drain-Kontakte begrenzen,

c) das Niederschlagen einer kontinuierlichen metallischen Schicht aus einer metallischen Zusammensetzung geeignet zum Bilden der ohmschen Source- und Drain-Kontakte,

d) das Niederschlagen einer dicken dielektrischen Schicht,

e) das Niederschlagen einer photoempfindlichen Lackschicht, die nach Behandlung die Öffnung begrenzt, die dem Gate-Kontakt entspricht,

f) das durch die Öffnung hindurch mittels einer Reihe selektiver chemischer Angriffe Ätzen der dicken dielektrischen Schicht, der kontinuierlichen metallischen Schicht, der dielektrischen Schicht und eines Teils der Dicke der aktiven N-leitenden Schicht so dass an dieser Stelle ein Hohlraum gebildet wird,

g) das Niederschlagen einer metallischen

Schicht zum Bilden des Gate-Kontaktes, wobei der gesamte Transistor und insbesondere der Boden des Hohlraumes bedeckt wird,

h) das Auflösen der photoempfindlichen Lackschicht, welche die obere metallische Schicht trägt, wodurch derjenige Teil dieser Schicht beibehalten wird, der in dem Hohlraum niedergeschlagen ist und der das Gate bildet und

i) das gesamte oder teilweise Auflösen der dicken dielektrischen Schicht.

8. Verfahren nach Anspruch 7, dadurch gekennzeichnet, dass in den die ohmschen Source- und Drain-Kontakte beschränkenden Öffnungen vor dem Niederschlagen der metallischen Schicht, welche diese Kontakte bildet, N+-leitende Inseln in der N-leitenden Schicht hergestellt sind.

9. Verfahren nach einem der Ansprüche 7 oder 8, dadurch gekennzeichnet, dass das Substrat aus halbisolierendem Galliumarsenid besteht.

10. Verfahren nach Anspruch 9, dadurch gekennzeichnet, dass die N-leitende aktive Schicht durch örtliche Implantation von Selenionen (Se+) in dem Substrat gebildet wird.

11. Verfahren nach Anspruch 8 und einem der Ansprüche 9 oder 10, dadurch gekennzeichnet, dass die N+-leitenden Inseln durch örtliche Implantation von Schwefelionen (Se+) in dem Substrat gebildet werden.

12. Verfahren nach einem der Ansprüche 7 bis 11, dadurch gekennzeichnet, dass die dielektrische Schicht eine photoempfindliche Lackschicht ist.

13. Verfahren nach einem der Ansprüche 7 bis 12, dadurch gekennzeichnet, dass die die ohmschen Kontakte bildende und die dielektrische Schicht bedeckende metallische Schicht eine Gold-Germaniumlegierung ist.

14. Verfahren nach einem der Ansprüche 7 bis 13, dadurch gekennzeichnet, dass die metallische Gate-Kontaktschicht aus der Überlagerung der Materialien Titan, Platin, Gold oder Chrom, Platin, Gold besteht, die eine Mehrfachschicht bilden.

## Claims

1. A field effect transistor for hyperfrequency applications comprising on a monocrystalline semi-insulating substrate a thin active n-type layer of a material having a high electron mobility, at the surface of which is deposited a metallic layer constituting two ohmic contacts forming the source and drain contact regions of the transistor, between which a metallic contact constitutes the gate electrode of the Schottky type, and comprising a dielectric layer disposed on the active layer between the source and gate electrodes on the one hand and between the gate and drain electrodes on the other hand, characterized in that the metallic layer constituting the ohmic contacts is prolonged continuously on this dielectric layer, but without causing a short-circuit with the gate, thus forming capacitances in the dielectric layer between the metallic layer and the subjacent active layer for diminishing the contact resistances.

2. A transistor as claimed in Claim 1, characterized in that in the region situated under the metallic layer constituting the ohmic contact islands of the n+ type are disposed in the n-type layer.

3. A transistor as claimed in Claim 1 or 2, characterized in that the substrate consists of semi-insulating gallium arsenide.

4. A transistor as claimed in any one of Claims 1 to 3, characterized in that the dielectric layer is a layer of a photosensitive lacquer.

5. A transistor as claimed in any one of Claims 1 to 4, characterized in that the metallic layer constituting the ohmic contacts and covering the dielectric layer consists of a gold-germanium alloy.

6. A transistor as claimed in any one of Claims 1 to 5, characterized in that the metallic gate contact layer is constituted by the superimposition of the metals titanium, platinum, gold or chromium, platinum, gold forming a multi-layer.

7. A method of manufacturing a field effect transistor as claimed in Claim 1, comprising the following steps:

a) forming a monocrystalline semi-insulating substrate provided with a monocrystalline n-type layer,

b) depositing a dielectric layer having openings defining the source and drain contacts,

c) depositing a metallic continuous layer of a metallic compound suitable to form the ohmic source and drain contacts,

d) depositing a thick dielectric layer,

e) depositing a layer of photosensitive lacquer, which after treatment defines the opening corresponding to the gate contact,

f) etching through this opening by means of a series of chemical selective attacks the thick dielectric layer, the metallic continuous layer, the dielectric layer, and a part of the thickness of the active n-type layer so as to form therein a cavity,

g) depositing a metallic layer suitable to form the gate contact covering the whole of the transistor and more particularly the bottom of this cavity,

h) dissolving the layer of photosensitive lacquer together with the upper metallic layer whilst maintaining the part of this layer deposited in the cavity and constituting the gate, and

i) entirely or partially dissolving the thick dielectric layer.

8. A method of manufacturing as claimed in Claim 7, characterized in that in the openings defining the source and drain ohmic contacts, before the deposition of the metallic layer constituting these contacts, n+ type islands are formed in the n-type layer.

9. A method of manufacturing as claimed in any one of Claims 7 or 8, characterized in that the substrate consists of semi-insulating gallium arsenide.

10. A method of manufacturing as claimed in Claim 9, characterized in that the active n-type layer is obtained by local implantation of selenium (Se+) ions in the substrate.

11. A method of manufacturing as claimed in Claim 8 and any one of Claims 9 or 10, characterized in that the n+-type islands are formed by local implantation of sulphur (S+) ions in the substrate.

12. A method of manufacturing as claimed in any one of Claims 7 to 11, characterized in that the dielectric layer is a layer of photosensitive lacquer.

13. A method of manufacturing as claimed in any one of Claims 7 to 12, characterized in that the metallic layer constituting the ohmic contacts and covering the dielectric layer consists of a gold-germanium alloy.

14. A method of manufacturing as claimed in any one of Claims 7 to 13, characterized in that the metallic gate contact layer is constituted by the super-imposition of the materials titanium, platinum, gold or chromium, platinum, gold forming a multilayer.

D
L

11  17        14    8      18  12      5

4

2

1

15                3

FIG.1a

D
L

2        8        5

1

17              18

FIG.1b

1

FIG.2a

FIG.2b

FIG.2c

FIG.2d

FIG.2e

FIG.2f

FIG.2g

FIG.3